(19) Europäisches Patentamt
European Patent Office
Office européen des brevets

(11) **EP 4 299 216 A1**

(12) **EUROPEAN PATENT APPLICATION**
published in accordance with Art. 153(4) EPC

(43) Date of publication:
**03.01.2024 Bulletin 2024/01**

(21) Application number: **22771398.9**

(22) Date of filing: **14.03.2022**

(51) International Patent Classification (IPC):
**B22F 7/08** (2006.01) **B22F 9/00** (2006.01)
**H01B 1/00** (2006.01) **H01B 1/22** (2006.01)
**H01L 21/60** (2006.01) **H01R 11/01** (2006.01)
**B22F 1/00** (2022.01) **B22F 1/052** (2022.01)
**B22F 1/06** (2022.01)

(52) Cooperative Patent Classification (CPC):
**B22F 1/00; B22F 1/052; B22F 1/06; B22F 7/08;
B22F 9/00; H01B 1/00; H01B 1/22; H01L 21/60;
H01R 11/01**

(86) International application number:
**PCT/JP2022/011427**

(87) International publication number:
**WO 2022/196653 (22.09.2022 Gazette 2022/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.03.2021 JP 2021043287**

(71) Applicant: **RESONAC CORPORATION**
**Tokyo 105-8518 (JP)**

(72) Inventors:
• **NATORI, Michiko**
**Minato-ku, Tokyo 105-8518 (JP)**
• **NAKAKO, Hideo**
**Minato-ku, Tokyo 105-8518 (JP)**
• **ISHIKAWA, Dai**
**Minato-ku, Tokyo 105-8518 (JP)**

(74) Representative: **Beckmann, Claus**
**Kraus & Weisert**
**Patentanwälte PartGmbB**
**Thomas-Wimmer-Ring 15**
**80539 München (DE)**

(54) **COPPER PASTE FOR FORMING SINTERED COPPER PILLARS AND METHOD FOR PRODUCING BONDED BODY**

(57) Copper paste for forming a sintered copper pillar containing copper particles and an organic dispersion medium, in which the copper paste contains first sub-micro copper particles having a volume-average particle size of 0.05 to 0.35 $\mu$m, second sub-micro copper particles having a volume-average particle size of 0.5 to 1.5 $\mu$m, and spherical micro copper particles having a volume-average particle size of 2 to 5 $\mu$m as the copper particles, a content of the first sub-micro copper particles is 40 to 70 % by mass on the basis of the total mass of the copper particles, a content of the second sub-micro copper particles is 10 to 40 % by mass on the basis of the total mass of the copper particles, and a content of the spherical micro copper particles is 15 to 45 % by mass on the basis of the total mass of the copper particles.

*Fig.1*

## Description

### Technical Field

The present invention relates to copper paste for forming a sintered copper pillar and a method for manufacturing a bonded body.

### Background Art

Solder bonding is typically used for electrical bonding in an electronic device. For example, in flip-chip bonding of a micro device, solder ball, solder paste, or the like are used for bonding between the micro device and an electrode pad on a substrate.

In recent, in the flip-chip bonding, in accordance with a reduction in pitch of terminals, a method in which a metal pillar is formed on the micro device, and the metal pillar and the electrode pad on the substrate are soldered is used. However, the solder bonding has problems such as (1) occurrence of kirkendall voids between the solder and the electrode pad and between the solder and the metal pillar, (2) occurrence of bonding defects due melting of the solder in a case where a reflow process is performed again after the bonding, (3) occurrence of signal reflection due to impedance mismatching at an interface of dissimilar metals, and the like.

In contrast to this, a method of performing bonding by using a metal other than solder has been examined. For example, Patent Literature 1 suggests a method of bonding a copper pillar provided on a micro device and a copper pad on a substrate by using an adhesive (copper paste) obtained by mixing copper microparticles and copper nanoparticles.

However, in the method disclosed in Patent Literature 1, it is necessary to form the copper pillar on the device in advance, and in a formation method with electroplating which is the mainstream method of forming the copper pillar, there is a problem that time is taken to form the pillar. In addition, another problem is that unevenness in height increases when increasing the plating rate.

Here, the present inventors have examined a method of forming a pillar precursor between bonding members by using copper paste containing copper particles and an organic dispersion medium, and sintering the pillar precursor to form a sintered copper pillar and to bond the bonding members (refer to Patent Literature 2). According to this method, the sintered copper pillar can be efficiently formed with accuracy.

### Citation List

### Patent Literature

Patent Literature 1: Specification of U.S. Patent Application Publication No. 2016/0351529
Patent Literature 2: Japanese Unexamined Patent Publication No. 2020-045514

### Summary of Invention

### Technical Problem

As a result of additional examination conducted by the present inventors, they found that voids and cracks may occur in the sintered copper pillar formed by using the copper paste, and peeling may occur at an interface of the sintered copper pillar and the bonding members. From the viewpoint of long-term reliability of a bonded body, it is preferable that the voids, the cracks, and the peeling are as small as possible.

Here, a main object of the invention is to provide copper paste for forming a sintered copper pillar which is capable of reducing voids and cracks in a sintered copper pillar, and peeling at an interface of the sintered copper pillar and bonding members.

### Solution to Problem

To accomplish the object, the present inventors examined using of a plurality of kinds of copper particles different in a volume-average particle size as copper particles to be contained in the copper paste. As a result, they found that the object can be accomplished by using spherical copper particles as micro copper particles while blending copper particles having specific volume-average particle sizes at a specific ratio, and they accomplished the invention.

An aspect of the invention relates to copper paste for forming a sintered copper pillar containing copper particles and an organic dispersion medium, in which the copper paste contains first sub-micro copper particles having a volume-average particle size of 0.05 to 0.35 $\mu$m, second sub-micro copper particles having a volume-average particle size of 0.5 to 1.5 $\mu$m, and spherical micro copper particles having a volume-average particle size of 2 to 5 $\mu$m as the copper particles, a content of the first sub-micro copper particles is 40 to 70 % by mass on the basis of the total mass of the copper particles, a content of the second sub-micro copper particles is 10 to 40 % by mass on the basis of the total mass of the copper particles, and a content of the spherical micro copper particles is 15 to 45 % by mass on the basis of the total mass of the copper particles.

According to the copper paste of the aspect, voids and cracks in a sintered copper pillar, and peeling at an interface of the sintered copper pillar and bonding members can be reduced.

In an embodiment, the first sub-micro copper particles may have a spherical shape, and the second sub-micro copper particles may have a flake shape. In this case, there is a tendency that peeling at the interface of the sintered copper pillar and the bonding members can be further reduced.

In an embodiment, a mass ratio of the content of the spherical micro copper particles to the total of the content of the first sub-micro copper particles and the content of the second sub-micro copper particles may be 0.20 to 0.50. In this case, there is a tendency that voids and cracks in the sintered copper pillar, and peeling at the interface of the sintered copper pillar and the bonding members tend to be further reduced.

In an embodiment, a mass ratio of the content of the second sub-micro copper particles to the content of the first sub-micro copper particles may be 0.15 to 0.45. In this case, voids and cracks in the sintered copper pillar, and peeling at the interface of the sintered copper pillar and the bonding members can be further reduced.

In an embodiment, the content of the organic dispersion medium may be 5 to 70 % by mass on the basis of the total mass of the copper paste. In this case, excellent printability and excellent sinterability of the copper paste are easy to be compatible with each other.

An another aspect of the invention relates to a method for manufacturing a bonded body including a first member, a second member, and a sintered copper pillar that bonds the first member and the second member to each other, in which the method includes: a step of forming the copper paste according to the above-described aspect in a pillar shape on the first member, and then mounting the second member on the first member to provide a pillar precursor between the first member and the second member; and a step of sintering the pillar precursor to form the sintered copper pillar.

According to the manufacturing method of the aspect, occurrence of voids and cracks in the sintered copper pillar of the bonded body, and peeling at the interface of the sintered copper pillar and the bonding members can be reduced.

**Advantageous Effects of Invention**

According to the invention, it is possible to provide copper paste for forming a sintered copper pillar which reduces occurrence of voids and cracks in a sintered copper pillar, and peeling at an interface of the sintered copper pillar and bonding members.

**Brief Description of Drawings**

FIG. 1 is a schematic cross-sectional view illustrating a bonded body of an embodiment.
FIG. 2 is a schematic cross-sectional view for explaining a method for manufacturing the bonded body in FIG. 1.
FIG. 3 is a schematic cross-sectional view for explaining the method for manufacturing the bonded body in FIG. 1.
FIG. 4 is a schematic cross-sectional view illustrating a bonded body of another embodiment.
FIG. 5 is a cross-sectional SEM image of bonded bodies manufactured in Experimental Examples 1 to 3.
FIG. 6 is a cross-sectional SEM image of the bonded body manufactured in Experimental Example 3.
FIG. 7 is a cross-sectional SEM image of bonded bodies manufactured in Experimental Examples 4 to 7.

**Description of Embodiments**

Hereinafter, embodiment for carrying out the invention will be described in detail. However, the invention is not limited to the following embodiments. In the following embodiments, constituent elements (also including elemental steps and the like) are not essential except a case of being explicitly state, a case of being apparently considered as being essential in principle, and the like. This is also true of numerical values, and ranges thereof, and the invention is not limited by the numerical values and the ranges.

In this specification, with regard to a terminology of "step", not only an independent step but also a step that is not clearly distinguished from other steps are included in the terminology as long as an object of the step is accomplished. In this specification, a numerical value range expressed by using "to" represents a range including numerical values described before and after "to" as a minimum value and a maximum value respectively. In a numerical value range described stepwise in this specification, an upper limit value or a lower limit value of a numerical value range of any stage may be replaced with an upper limit value or a lower limit value of a numerical value range of another stage. In addition, in the numerical value range described in this specification, an upper limit value or a lower limit value of the numerical value range may be replaced with a value described in Examples. In addition, an upper limit value and a lower limit value described individually can be combined in any manner. In this specification, with regard to the content of each component in a composition, in a case where a plurality of kinds of substances corresponding to each component exist in the composition, the content represents a total amount of the plurality of kinds of substances existing in the composition unless otherwise stated. In this specification, "a boiling point" represents a boiling point at 1 atmosphere.

<Copper Paste>

Copper paste of one embodiment contains copper particles and an organic dispersion medium. The copper paste is a copper paste for forming a sintered copper pillar that bonds members to each other (copper paste for forming the sintered copper pillar), and specifically, used to manufacture a bonded body including a first member, a second member, and a sintered copper pillar that bonds the first member and the second member. The copper paste of this embodiment is preferably used in a method of bonding members to be bonded through sintering without pressurization.

The copper paste contains first sub-micro copper particles having a volume-average particle size of 0.05 to 0.35 $\mu$m, second sub-micro copper particles having a volume-average particle size of 0.5 to 1.5 $\mu$m, and spherical micro copper particles having a volume-average particle size of 2 to 5 $\mu$m as the copper particles. The content of the first sub-micro copper particles is 40 to 70 % by mass on the basis of the total mass of the copper particles, the content of the second sub-micro copper particles is 10 to 40 % by mass on the basis of the total mass of the copper particles, and the content of the spherical micro copper particles is 15 to 45% by mass on the basis of the total mass of the copper particles.

According to the copper paste, occurrence of voids and cracks in a sintered copper pillar, and peeling at an interface of the sintered copper pillar and bonding members (the first member and/or the second member) can be reduced.

(Copper Particles)

The copper particles represent particles containing copper as a main component, and, for example, represent particles in which a content ratio of copper in the particles is 80% by mass or more. The content ratio of copper in the copper particles may be 85% by mass or more, 90% by mass or more, 95% by mass or more, or 99% by mass or more.

The copper paste of this embodiment contains first sub-micro copper particles, second sub-micro copper particles, and spherical micro copper particles as the copper particles.

[First Sub-micro Copper Particle]

The first sub-micro copper particles are copper particles having a volume-average particle size of 0.05 to 0.35 $\mu$m. As the first sub-micro copper particles, for example, copper particles having sinterability in a temperature range of 150°C or more and 300°C or less can be used.

The volume-average particle size of the first sub-micro copper particles may be 0.1 $\mu$m or more or 0.2 $\mu$m or more from the viewpoint that more satisfactory dispersibility is likely to be obtained, voids and cracks in the sintered copper pillar and peeling at the interface of the sintered copper pillar and the bonding members are further easily reduced. The volume-average particle size of the first sub-micro copper particles may be 0.3 $\mu$m or less, 0.2 $\mu$m or less, or 0.1 $\mu$m or less from the viewpoint of further easily reducing voids and cracks in the sintered copper pillar. From the viewpoints, the volume-average particle size of the first sub-micro copper particles may be, for example, 0.05 to 0.3 $\mu$m, 0.1 to 0.3 $\mu$m, 0.1 to 0.2 $\mu$m, 0.05 to 0.1 $\mu$m, or 0.2 to 0.3 $\mu$m.

Note that, in this specification, the volume-average particle size represents 50% volume-average particle size. In a case of obtaining the volume-average particle size of the copper particles, the volume-average particle size can be obtained by a method of measuring that of a product obtained by dispersing copper particles as a raw material or dried copper particles obtained by removing volatile components from copper paste in a dispersion medium by using a dispersant, by a light-scattering-method particle size distribution measuring device (for example, a Shimadzu nano particle size distribution measuring device (SALD-7500 nano, manufactured by SHIMADZU CORPORATION)), or the like method. In a case of using the light-scattering-method particle size distribution measuring device, as the dispersion medium, hexane, toluene, $\alpha$-terpineol, 4-methyl-1,3-dioxolan-2-one, or the like can be used.

A shape of the first sub-micro copper particles is not particularly limited. Examples of the shape of the first sub-micro copper particles include a spherical shape, a lump shape, a needle shape, a columnar shape, a flake shape, and aggregates thereof. The shape of the first sub-micro copper particles may be the spherical shape or the flake shape from the viewpoint of dispersibility and a filling property, and may be the spherical shape from the viewpoint of combustibility, dispersibility, a mixing property with other copper particles (for example, flake-shape copper particles), and the like. Note that, in this specification, "spherical shape" represents a sphere in which an aspect ratio of a particle (long side/short side of the particle) is 2 or less. Measurement of the long side and the short side of the particle can be obtained, for example, from a SEM image of the particle. In this specification, the "flake shape" includes a flat-plate shape such as a plate shape and a scale shape.

The aspect ratio of the first sub-micro copper particles may be 2 or less or 1.5 or less from the viewpoint of improving the dispersibility, the filling property, the mixing property with other copper particles (for example, flake-shaped copper particles), and printability of the copper paste.

A specific surface area of the first sub-micro copper particles may be 1 $m^2/g$ or more, 2 $m^2/g$ or more, or 4 $m^2/g$ or more from the viewpoint of dispersibility of paste. The specific surface area of the first sub-micro copper particles may be 10 $m^2/g$ or less, 8 $m^2/g$ or less, or 5 $m^2/g$ or less from the viewpoint of improving electrical conductivity and heat dissipation performance of the sintered copper pillar. From the viewpoints, the specific surface area of the first sub-micro copper particles may be 1 to 10 $m^2/g$, 2 to 8 $m^2/g$, or 4 to 5 $m^2/g$.

The first sub-micro copper particles may be treated with a surface treatment agent. Examples of the surface treatment agent include an organic acid having 2 to 18 carbon atoms (for example, an organic acid having an alkyl group having 1 to 17 carbon atoms). Examples of the organic acid having 2 to 18 carbon atoms include saturated fatty acids such as acetic acid, propanoic acid, butanoic acid, pentanoic acid, hexanoic acid, heptanoic acid, caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyltridecanoic acid, ethyldodecanoic acid, propylundecanoic acid, butyldecanoic acid, pentylnonanoic acid, hexyloctanoic acid, pentadecanoic acid, methyltetradecanoic acid, ethyltridecanoic acid, propyldodecanoic acid, butylundecanoic acid, pentyldecanoic acid, hexylnonanoic acid, palmitic acid, methylpentadecanoic acid, ethyltetradecanoic acid, propyltridecanoic acid, butyldodecanoic acid, pentyl undecanoic acid, hexyldecanoic acid, heptylnonanoic acid, heptadecanoic acid, octadecanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, sapienic acid, oleic acid, vaccenic acid, linoleic acid, and linolenic acid; and aromatic carboxylic acids such as terephthalic acid, pyromellitic acid, o-phenoxybenzoic acid, methylbenzoic acid, ethylbenzoic acid, propylbenzoic acid, butylbenzoic acid, pentylbenzoic acid, hexylbenzoic acid, heptylbenzoic acid, octylbenzoic acid, and nonylbenzoic acid. When combining the organic acids and the first sub-micro copper particles, dispersibility of the first sub-micro copper particles and the release property of the organic acids during sintering tend to be compatible with each other. With regard to the organic acids, one kind may be used alone or two or more kinds may be used in combination.

The treatment amount of the surface treatment agent may be 0.07% by mass or more and 2.1% by mass or less, 0.10% by mass or more and 1.6% by mass or less, or 0.2% by mass or more and 1.1% by mass or less.

As the first sub-micro copper particles, commercially available product can be used. Examples of the commercially available product include CH-0200 (manufactured by MITSUI MINING & SMELTING CO., LTD., a volume-average particle size: 0.26 $\mu$m, CuC-40 (manufactured by FUKUDA METAL FOIL & POWDER CO., LTD., a volume-average particle size: 0.30 $\mu$m), and Cp-250 (manufactured by Techno Alpha Co., Ltd., a volume-average particle size: 0.25 $\mu$m).

The content of the first sub-micro copper particles is 40 to 70% by mass on the basis of the total mass of the copper particles. The content of the first sub-micro copper particles may be 45% by mass or more or 50% by mass or more on the basis of the total mass of the copper particles from the viewpoint of further reducing voids and cracks in the sintered copper pillar. The content of the first sub-micro copper particles may be 65% by mass or less or 55% by mass or less on the basis of the total mass of the copper particles from the viewpoint of further reducing peeling at the interface of the sintered copper pillar and the bonding members. From the viewpoints, the content of the first sub-micro copper particles may be 45 to 65 % by mass, 45 to 55 % by mass, or 50 to 55 % by mass on the basis of the total mass of the copper particles. In this embodiment, the content of the first sub-micro copper particles based on the total mass of the first sub-micro copper particles, the second sub-micro copper particles, and the spherical micro copper particles may be within the above-described ranges.

[Second Sub-micro Copper Particles]

The second sub-micro copper particles are copper particles having a volume-average particle size of 0.5 to 1.5 μm. As the second sub-micro copper particles, for example, copper particles having sinterability in a temperature range of 150°C or more and 300°C or less can be used.

The volume-average particle size of the second sub-micro copper particles may be 0.8 μm or more or 1.0 μm or more from the viewpoint that more satisfactory dispersibility is likely to be obtained, and voids and cracks in the sintered copper pillar, and peeling at the interface of the sintered copper pillar and the bonding members are further easily reduced. The volume-average particle size of the second sub-micro copper particles may be 1.3 μm or less, 1.2 μm or less, 0.9 μm or less, or 0.6 μm or less from the viewpoint of further easily reducing voids and cracks in the sintered copper pillar. From the viewpoints, the volume-average particle size of the second sub-micro copper particles may be 0.8 to 1.3 μm, 1.0 to 1.2 μm, 0.5 to 0.9 μm, or 0.5 to 0.6 μm.

A shape of the second sub-micro copper particles is not particularly limited. Examples of the shape of the second sub-micro copper particles include a spherical shape, a lump shape, a needle shape, a columnar shape, a flake shape, and aggregates thereof. The shape of the second sub-micro copper particles may be the spherical shape or the flake shape from the viewpoint of dispersibility and a filling property. In a case where the first sub-micro copper particles have the spherical shape, the second sub-micro copper particles may have the flake shape. In this case, the second sub-micro copper particles having the flake shape are oriented in approximately parallel to a bonding surface in the pillar precursor, so that there is a tendency that volume shrinkage in a bonding surface direction of the pillar precursor during sintering can be suppressed, and peeling at the interface of the sintered copper pillar and the bonding members can be further reduced. Particularly, in a case where the bonding members are micro devices, the micro devices tend to show satisfactory die shear strength and connection reliability. From the viewpoint that the effect becomes remarkable, an aspect ratio of the second sub-micro copper particles having the flake shape may be 2 to 10.

A specific surface area of the second sub-micro copper particles may be 1 m²/g or more, 2 m²/g or more, 3 m²/g or more, or 4 m²/g or more from the viewpoint of dispersibility of paste. The specific surface area of the second sub-micro copper particles may be 10 m²/g or less, 8 m²/g or less, 5 m²/g or less, or 4 m²/g or less from the viewpoint of improving electrical conductivity and heat dissipation performance of the sintered copper pillar. From the viewpoints, the specific surface area of the second sub-micro copper particles may be 1 to 10 m²/g, 2 to 8 m²/g, 3 to 4 m²/g, or 4 to 5 m²/g.

The second sub-micro copper particles may be treated with a surface treatment agent. As the surface treatment agent, the organic acids exemplified as the surface treatment agent of the first sub-micro copper particles can be exemplified. With regard to the organic acids, one kind may be used alone or two or more kinds may be used in combination. The treatment amount of the surface treatment agent may be similar as in the first sub-micro copper particles.

As the second sub-micro copper particles, commercially available product can be used. Examples of the commercially available product include CT-500 (manufactured by MITSUI MINING & SMELTING CO., LTD., a volume-average particle size: 0.51 μm), EFC-20 (manufactured by FUKUDA METAL FOIL & POWDER CO., LTD., a volume-average particle size: 0.56 μm), EFC-09 (manufactured by FUKUDA METAL FOIL & POWDER CO., LTD., a volume-average particle size: 1.26 μm), FMC-SB (manufactured by FURUKAWA CHEMICALS CO., LTD., a volume-average particle size: 0.8 μm), and CP-1500 (manufactured by Techno Alpha Co., Ltd., a volume-average particle size: 1.5 μm).

The content of the second sub-micro copper particles is 10 to 40 % by mass on the basis of the total mass of the copper particles. The content of the second sub-micro copper particles may be 15% by mass or more or 20% by mass or more on the basis of the total mass of the copper particles from the viewpoint of further reducing peeling at the interface of the sintered copper pillar and the bonding members. The content of the second sub-micro copper particles may be 35% by mass or less or 30% by mass or less on the basis of the total mass of the copper particles from the viewpoint of further reducing voids and cracks in the sintered copper pillar. From the viewpoints, the content of the second sub-micro copper particles may be 20 to 40 % by mass, 15 to 35 % by mass, or 20 to 30 % by mass on the basis of the total mass of the copper particles. In this embodiment, the content of the second sub-micro copper particles based on the total mass of the first sub-micro copper particles, the second sub-micro copper particles, and the spherical micro copper particles may be within the above-described ranges.

A mass ratio ([the content of the second sub-micro copper particles]/[the content of the first sub-micro copper particles]) of the content of the second sub-micro copper particles to the content of the first sub-micro copper particles may be 0.15 or more, 0.20 or more, 0.22 or more, or 0.25 or more from the viewpoint of further reducing peeling at the interface of the sintered copper pillar and the bonding members. The mass ratio of the content of the second sub-micro copper particles to the content of the first sub-micro copper particles may be 0.45 or less, 0.40 or less, or 0.35 or less from the viewpoint of further reducing voids and cracks in the sintered copper pillar. From the viewpoints, the mass ratio of the content of the second sub-micro copper particles to the content of the first sub-micro copper particles may be 0.15 to 0.45, 0.20 to 0.45, 0.20 to 0.40, 0.22 to 0.40, or 0.25 to 0.35.

[Spherical Micro Copper Particles]

The spherical micro copper particles are spherical copper particles having a volume-average particle size of 2 to 5 $\mu$m.

A volume-average particle size of the spherical micro copper particles may be 2.5 $\mu$m or more or 3 $\mu$m or more from the viewpoint of suppressing cracks occurring in the pillar during bonding and improving electrical conductivity and heat dissipation performance of the sintered copper pillar. The volume-average particle size of the spherical micro copper particles may be 4.5 $\mu$m or less, 3.5 $\mu$m or less, or 3 $\mu$m or less from the viewpoint of improving dispersibility and printability. From the viewpoints, the volume-average particle size of the spherical micro copper particles may be 2 to 3 $\mu$m, 2.5 to 4.5 $\mu$m, or 3 to 3.5 $\mu$m.

A specific surface area of the spherical micro copper particles may be 0.1 m$^2$/g or more, 0.4 m$^2$/g or more, 1 m$^2$/g or more, 2 m$^2$/g or more, or 4 m$^2$/g or more from the viewpoint of dispersibility of paste. The specific surface area of the spherical micro copper particles may be 10 m$^2$/g or less, 8 m$^2$/g or less, 5 m$^2$/g or less, 1 m$^2$/g or less, or 0.5 m$^2$/g or less from the viewpoint of improving electrical conductivity and heat dissipation performance of the sintered copper pillar. From the viewpoints, the specific surface area of the spherical micro copper particles may be 1 to 10 m$^2$/g, 2 to 8 m$^2$/g, 4 to 5 m$^2$/g, 0.1 to 1 m$^2$/g, or 0.4 to 0.5 m$^2$/g.

The spherical micro copper particles may be treated with a surface treatment agent from the viewpoint of dispersion stability and oxidation resistance. The surface treatment agent may be surface treatment agent that is removed during bonding. Examples of the surface treatment agent include aliphatic carboxylic acids such as dodecanoic acid, palmitic acid, heptadecanoic acid, stearic acid, arachidic acid, linoleic acid, linolenic acid, and oleic acid; aromatic carboxylic acids such as terephthalic acid, pyromellitic acid, and o-phenoxybenzoic acid; aliphatic alcohols such as cetyl alcohol, stearyl alcohol, isobornylcyclohexanol, and tetraethylene glycol; aromatic alcohol such as p-phenyl phenol; alkylamines such as octylamine, dodecylamine, and stearylamine; aliphatic nitriles such as stearonitrile and decanenitrile; silane coupling agents such as alkylalkoxysilanes; and polymer treatment agents such as polyethylene glycol, polyvinyl alcohol, polyvinylpyrrolidone, and silicone oligomer. With regard to the surface treatment agents, one kind may be used alone or two or more kinds may be used in combination.

As the spherical micro copper particles, commercially available product can be used. Examples of the commercially available spherical micro copper particles include MA-C025K (manufactured by FUKUDA METAL FOIL & POWDER CO., LTD., a volume-average particle size: 2.65 $\mu$m), and CP-2500 (manufactured by Techno Alpha Co., Ltd., a volume-average particle size: 2.5 $\mu$m).

The content of the spherical micro copper particles is 15 to 45 % by mass on the basis of the total mass of the copper particles. The content of the spherical micro copper particles may be 20% by mass or more or 25% by mass or more on the basis of the total mass of the copper particles from the viewpoint of further easily reducing peeling at the interface of the sintered copper pillar and the bonding members, and improving electrical conductivity and heat dissipation of the sintered copper pillar. The content of the spherical micro copper particles may be 40% by mass or less or 35% by mass or less on the basis of the total mass of the copper particles from the viewpoint of further reducing voids and cracks in the sintered copper pillar, and improving printability of the copper paste. From the viewpoints, the content of the spherical micro copper particles may be 20 to 40 % by mass or 25 to 35 % by mass on the basis of the total mass of the copper particles. In this embodiment, the content of the spherical micro copper particles on the basis of the total mass of the first sub-micro copper particles, the second sub-micro copper particles, and the spherical micro copper particles may be within the above-described range.

A mass ratio ([the content of the spherical micro copper particles]/[the total content of the first sub-micro copper particles and the second sub-micro copper particles]) of the content of the spherical micro copper particles to the total of the content of the first sub-micro copper particles and the content of the second sub-micro copper particles may be 0.20 or more, 0.25 or more, or 0.30 or more from the viewpoint of further easily reducing peeling at the interface of the sintered copper pillar and the bonding members, and improving electrical conductivity and heat dissipation performance of the sintered copper pillar. The mass ratio of the content of the spherical micro copper particles to the total of the content of the first sub-micro copper particles and the content of the second sub-micro copper particles may be 0.50 or less, 0.48 or less, or 0.45 or less from the viewpoint of further reducing voids and cracks in the sintered copper pillar and improving printability of the copper paste. From the viewpoints, the mass ratio of the content of the spherical micro copper particles to the total of the content of the first sub-micro copper particles and the content of the second sub-micro copper particles may be 0.20 to 0.50, 0.25 to 0.48, or 0.30 to 0.45.

The copper paste of this embodiment may contain only the first sub-micro copper particles, the second sub-micro copper particles, and the spherical micro copper particles as the copper particles, or may further contain copper particles other than the first sub-micro copper particles, the second sub-micro copper particles, and the spherical micro copper particles. The total content of the first sub-micro copper particles, the second sub-micro copper particles, and the spherical micro copper particles may be 90% by mass or more, 95% by mass or more, or 99% by mass or more on the basis of the total mass of the copper paste.

(Organic Dispersion Medium)

The organic dispersion medium includes an organic dispersion medium having a boiling point of lower than 300°C and/or an organic dispersion medium having a boiling point of 300°C or higher.

Examples of the organic dispersion medium having a boiling point of lower than 300°C include α-terpineol, diethylene glycol monobutyl ether, diethylene glycol monobutyl ether acetate, 4-methyl-1,3-dioxolan-2-one, and diethylene glycol monobutyl ether. The organic dispersion medium having a boiling point of lower than 300°C can be easily removed in a drying process or a temperature rising process before sintering the pillar precursor. With regard to the organic dispersion media having a boiling point of lower than 300°C, one kind may be used alone or a plurality of kinds may be used in combination.

The content of the organic dispersion medium having a boiling point of lower than 300°C may be 0 to 50 % by mass, 10 to 40 % by mass, or 20 to 30 % by mass on the basis of the total mass of the organic dispersion medium from the viewpoint of promoting sintering of the copper particles.

With regard to the organic dispersion medium having a boiling point of 300°C or higher, it is preferable to select a structure having high affinity with a copper particle surface to improve dispersibility of the copper particles. In a case where the copper particles are subjected to a surface treatment with the surface treatment agent including an alkyl group, it is preferable to select an organic dispersion medium having an alkyl group. Examples of the organic dispersion medium having a boiling point of 300°C or higher include isobomylcyclohexanol (MTPH, manufactured by Nippon Terpene Chemicals, Inc.), butyl stearate, Exceparl BS (manufactured by Kao Corporation), stearyl stearate, Exceparl SS (manufactured by Kao Corporation), 2-ethylhexyl stearate, Exceparl EH-S (manufactured by Kao Corporation), isotridecyl stearate, Exceparl TD-S (manufactured by Kao Corporation), isooctadecanol, fineoxocol 180 (manufactured by Nissan Chemical Corporation), fineoxocol 180T (manufactured by Nissan Chemical Corporation), 2-hexyldecanol, fineoxocol 1600 (manufactured by Nissan Chemical Corporation), tributyrin, tetraethylene glycol, heptadecane, octadecane, nonadecane, eicosane, heneicosane, docosane, methylheptadecane, tridecylcyclohexane, tetradecylcyclohexane, pentadecylcyclohexane, hexadecylcyclohexane, undecylbenzene, dodecylbenzene, tetradecylbenzene, tridecylbenzene, pentadecylbenzene, hexadecylbenzene, heptadecylbenzene, nonylnaphthalene, diphenylpropane, octyl octanoate, methyl myristate, ethyl myristate, methyl linoleate, methyl stearate, triethylene glycol bis(2-ethylhexanoic acid), tributyl citrate, pentylphenol, dibutyl sebacate, oleyl alcohol, cetyl alcohol, methoxyphenethyl alcohol, benzylphenol, hexadecanenitrile, heptadecanenitrile, benzyl benzoate, and cinmethylin. With regard to the organic dispersion media having a boiling point of 300°C or higher, one kind can be used alone or a plurality of kinds can be used in combination.

As the organic dispersion medium having a boiling point of 300°C or higher, an organic dispersion medium having a boiling point of 310°C or higher is more preferable. The dispersion medium having the boiling point remains in the pillar precursor up to a firing temperature of 150°C to 300°C and contributes to maintenance of adhesion and flexibility. On the other hand, as the organic dispersion medium having a boiling point of 300°C or higher, an organic dispersion medium having a boiling point of 450°C or lower is preferable, and an organic dispersion medium having a boiling point of 400°C or lower is more preferable. The organic dispersion medium is volatilized and removed due to a vapor pressure thereof even at a temperature equal to or lower than the boiling point, but in a case of using the organic dispersion medium having a boiling point of 450°C or lower, a volatilization rate does not become excessively slow at a sintering temperature of 150°C to 300°C, and sintering inhibition due to remaining dispersion medium is less likely to occur.

The content of the organic dispersion medium having a boiling point of 300°C or higher may be 50 to 100 % by mass, 55 to 95 % by mass, or 60 to 90 % by mass on the basis of the total mass of the organic dispersion medium from the viewpoint of improving printability of the copper paste and from the viewpoint of suppressing cracks and peeling of the pillar during sintering.

The content of the organic dispersion medium may be 1% by mass or more, 5% by mass or more, 10% by mass or more, or 15% by mass or more on the basis of the total mass of the copper paste from the viewpoint of adjusting the copper paste to have more appropriate viscosity. The content of the organic dispersion medium may be 70% by mass or less, 65% by mass or less, 60% by mass or less, 50% by mass or less, 20% by mass or less, or 10% by mass or less on the basis of the total mass of the copper paste from the viewpoint of further improving sinterability of the copper particles. From the viewpoints, the content of the organic dispersion medium may be 1 to 70 % by mass, 5 to 70 % by mass, 5 to 65 % by mass, 10 to 60 % by mass, 15 to 50 % by mass, 1 to 20 % by mass, or 1 to 10 % by mass on the basis of the total mass of the copper paste.

The kind of the organic dispersion medium contained in the copper paste can be analyzed, for example, by a high-temperature desorption gas chromatograph-mass spectrometry, and a TOF-SIMS. With regard to another analysis method, a supernatant obtained by separating particle components through centrifugation may be identified by ordinary organic analysis, for example, FT-IR, NMR, liquid chromatograph, and a combination thereof. A ratio of the kind of the organic dispersion medium can be quantified by liquid chromatograph, NMR, and the like.

(Other Components)

The copper paste may further contain components other than the copper particles, and the organic dispersion medium. Examples of the components other than the copper particles and the organic dispersion medium include metal particles other than copper particles, a flexibility imparting component such as a thermally decomposable resin, a filling material, a dispersant, and a flux.

The viscosity of the copper paste may be viscosity suitable for a printing and application method for forming a pillar precursor. From the viewpoint that formation of the pillar precursor by various printing methods to be described later becomes easy, the viscosity of the copper paste at 25°C may be 50 Pa·s or more and 2000 Pa·s or less, 100 Pa·s or more and 1750 Pa·s or less, or 200 Pa·s or more and 1500 Pa·s or less. Note that, the viscosity of the copper paste represents a value measured by an E-type viscometer at 25°C under the condition in which the number of revolutions is set to 0.5 rpm. As the E-type viscometer, for example, VISCOMETER-TV33 type viscometer (product name, manufactured by Toki Sangyo Co., Ltd.) can be used. As a measuring jig of cone rotor, for example, 3°×R14, SPP is applicable.

A thixotropic index (hereinafter, referred to as "TI value") of the copper paste may be 2.0 or more and 20 or less, 3.0 or more and 15 or less, or 4.0 or more and 10 or less. When the TI value of the copper paste is within the range, the copper paste becomes less viscous due to a shear force, so that printing of the copper paste becomes easy by stirring the copper paste by hand or with a stirrer (for example, a rotation and revolution type stirrer (Planetary Vacuum Mixer ARV-310, manufactured by THINKY CORPORATION), or the like), and also, after being attached to the bonding members, viscosity of the copper paste is recovered by being stood still, so that excessive wetting and spreading of a printed matter can be suppressed. Note that, the TI value of the copper paste is a value calculated by the following expression when the viscosity measured by the E-type viscometer at 25°C under the condition in which the number of revolutions is set to 0.5 rpm is set as $\mu_{0.5}$ and the viscosity measured by the E-type viscometer at 25°C under the condition in which the number of revolutions is set to 5 rpm is set as $\mu_5$.

$$\text{TI value} = \mu_{0.5}/\mu_5$$

<Method for Manufacturing Copper Paste>

The copper paste of the above-described embodiment can be prepared by mixing the first sub-micro copper particles, the second sub-micro copper particles, the spherical micro copper particles, the organic dispersion medium, and any components (a flexibility imparting component or the like) that is blended as necessary. The copper paste may be prepared by simultaneously mixing the components, or may be prepared by mixing the components in a plurality of batches. For example, after preparing intermediate slurry by mixing the organic dispersion medium, the first sub-micro copper particles, and any component, the intermediate slurry, the second sub-micro copper particles, the spherical micro copper particles, the organic dispersion medium, and any component may be mixed to prepare the copper paste. A dispersion treatment may be performed during mixing. In addition, after mixing the respective components, a stirring treatment may be performed.

The dispersion treatment can be performed by using a disperser or a stirrer. Examples of the disperser and the stirrer include an ishikawa-type stirrer, a silverson stirrer, a cavitation stirrer, a rotation and revolution type stirrer, an ultra-thin film high-speed rotation type disperser, an ultrasonic disperser, a raikai machine, a biaxial kneader, a bead mill, a ball mill, a triple roll mill, a homomixer, a planetary mixer, an ultra-high pressure type disperser, and a thin-layer shear disperser.

The stirring treatment can be performed by using a stirrer. Examples of the stirrer include the ishikawa-type stirrer, the rotation and revolution type stirrer, the raikai machine, the biaxial kneader, the triple roll mill, and the planetary mixer.

In this preparation method, aggregates may be removed by performing a classification operation. In addition, a maximum particle size of the copper particles may be adjusted by the classification operation. The classification operation can be performed, for example, by using filtration, natural sedimentation, centrifugation, or the like. Examples of a filter for filtration include a water comb, a metal mesh, a metal filter, and a nylon mesh.

<Bonded Body>

A bonded body prepared by using the copper paste of the above-described embodiment, and a method for manufacturing the bonded body will be described.

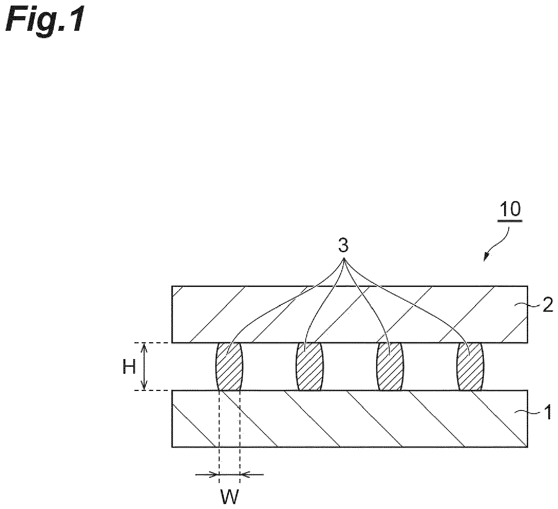

FIG. 1 is a schematic cross-sectional view illustrating a bonded body of an embodiment. A bonded body 10 illustrated in FIG. 1 includes a first member 1, a second member 2, a sintered copper pillar 3 that bonds the first member 1 and the second member 2. The sintered copper pillar 3 is composed of the copper paste sintered body of the above-described embodiment.

A lower surface and an upper surface of the sintered copper pillar form a bonding surface with the first member and a bonding surface with the second member, respectively, and both the first and second members are bonded to the sintered copper pillar by a metallic bond. Since such metallic bond is formed, the bonded body can be strongly bonded with low electrical resistance.

Examples of the first member 1 and the second member 2 include active or passive electronic devices, a wiring board on which an electronic device is mounted, and a package including an electronic device and a rewiring layer provided on the electronic device.

Examples of the electronic devices include a coil, a capacitor, a SAW filter, a power IC, a logic chip, a memory chip, a sensor, a piezoelectric element, a transistor, and a diode.

Examples of the wiring board include a mounting board, a lead frame such as a copper lead frame, a ceramic board, a resin molded product including a printed metal wiring such as molded interconnect device (MID, a molded circuit part), and a package including a rewiring layer.

One of the first member 1 and the second member 2 may be an active or passive electronic device, and the other may be a wiring board on which the electronic device is mounted. In this case, the electronic device can be mounted with excellent reliability.

In addition, both the first member 1 and the second member 2 may be a package including the electronic device and the rewiring layer provided on the electronic device. In this case, package-on-package mounting with excellent reliability becomes possible.

The first member 1 and/or the second member 2 may contain one or more kinds of metals selected from the group consisting of copper, nickel, silver, platinum, gold, and palladium on the bonding surfaces with the sintered copper pillar 3. Specifically, for example, a metal film or a sintered metal layer containing one or more kinds of metals selected from the group consisting of copper, nickel, silver, platinum, gold, and palladium may be provided on the first member 1 and/or the second member 2. In a case where the bonding surfaces contain these metals, an oxide film on the surfaces can be reduced and removed under a reducing gas atmosphere such as hydrogen and a formic acid at a sintering temperature of 300°C or lower. Accordingly, the bonded body 10 can have high bonding strength due to the metallic bond between exposed metal surfaces of the members and the sintered copper pillar.

In the sintered copper pillar 3, the content of copper is preferably 96% by mass or more on the basis of the total mass of components (however, excluding carbon, oxygen, and nitrogen) constituting the sintered copper pillar, more preferably 96.5% by mass or more, and still more preferably 97% by mass or more. Note that, the above-described carbon, oxygen, and nitrogen are components that may be unintentionally contained in the sintered copper pillar due to underfill filling by mounting or filling with a sealing material.

The sintered copper pillar in which the content of copper is within the above-described range can be easily formed by printing and sintering of the above-described copper paste. In addition, when the content of copper in the sintered copper pillar is within the above-described range, it is advantageous from the viewpoint of securement of bonding strength and suppression of electromigration. In addition, in a case where the bonding surfaces contain copper, since bonding by the same kind of metal is obtained, occurrence of Kirkendall voids is easily suppressed, and a bonded body with further excellent connection reliability can be obtained.

With regard to the sintered copper pillar 3, from the viewpoint of thermal conductivity and electrical conductivity, a volume ratio of copper in the sintered copper pillar 3 is preferably 50% by volume or more, more preferably 60% by volume or more, and still more preferably 70% by volume or more. The larger the volume ratio of copper in the sintered copper pillar 3 is, the higher thermal conductivity and electrical conductivity of the sintered copper pillar 3 becomes. The volume ratio of copper in the sintered copper pillar 3 can be obtained from a SEM image of a cross-section of the sintered copper pillar. Note that, in this specification, a portion of the sintered copper pillar other than copper is expressed as a vacancy (void). In a case where a filling material or a resin component such as an underfill is included in the vacancy, a volume of the component is also included as a volume of the vacancy.

A height H of the sintered copper pillar 3 may be 5 to 200 $\mu$m, 10 to 150 $\mu$m, or 20 to 100 $\mu$m. Here, the height of the sintered copper pillar 3 represents the shortest distance between the bonding surface of the first member 1 and the bonding surface of the second member 2 in the sintered copper pillar 3.

A width (diameter) W of the sintered copper pillar 3 may be 10 to 500 $\mu$m, 25 to 300 $\mu$m, or 50 to 150 $\mu$m. Here, the width (diameter) of the sintered copper pillar 3 represents the smallest diameter of a cross-section orthogonal to a height direction (a pillar extending direction) of the sintered copper pillar 3. From the viewpoint of reducing a thermal stress after bonding, the width (diameter) W of the sintered copper pillar 3 may be 100 to 200 $\mu$m, 125 $\mu$m to 175 $\mu$m, or 140 to 160 $\mu$m.

In the sintered copper pillar 3, a ratio (H/W) (may be referred to as "cross-sectional aspect ratio of the sintered copper pillar") of the height H and the width W may be 0.01 to 4.0, 0.1 to 2.5, or 0.15 to 2.0.

The height H and the width W can be obtained from a SEM image of a cross-section of the sintered copper pillar.

Shear strength at an interface of the sintered copper pillar 3 and the first member and/or the second member (shear strength between the bonding surface of the sintered copper pillar 3 and the bonding surfaces of the first member and/or the second member) can be set to 4 MPa or more, and may be 10 MPa or more, or 20 MPa or more. At this time, the bonding surfaces of the first member and/or the second member can contain the above-described metal. For example, the bonding surfaces of the first member and/or the second member may be a surface of a metal layer containing the above-described metal.

The shear strength can be calculated by using, for example, a bonding strength test device, pressing the sintered copper pillar in a horizontal direction at a constant speed with a device tool, and dividing the maximum strength when the bonding surface of the sintered copper pillar and the member is peeled off by a cross-sectional area of the pillar.

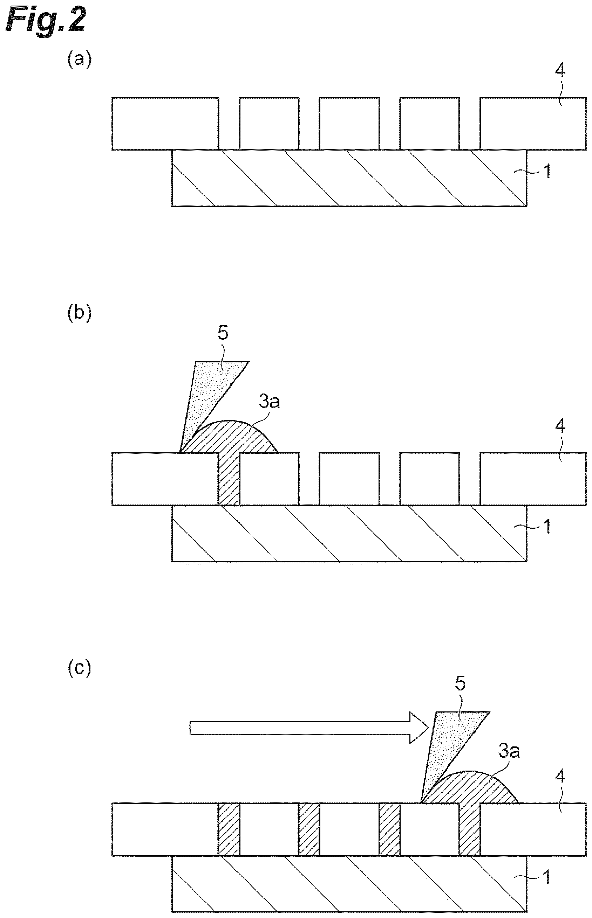

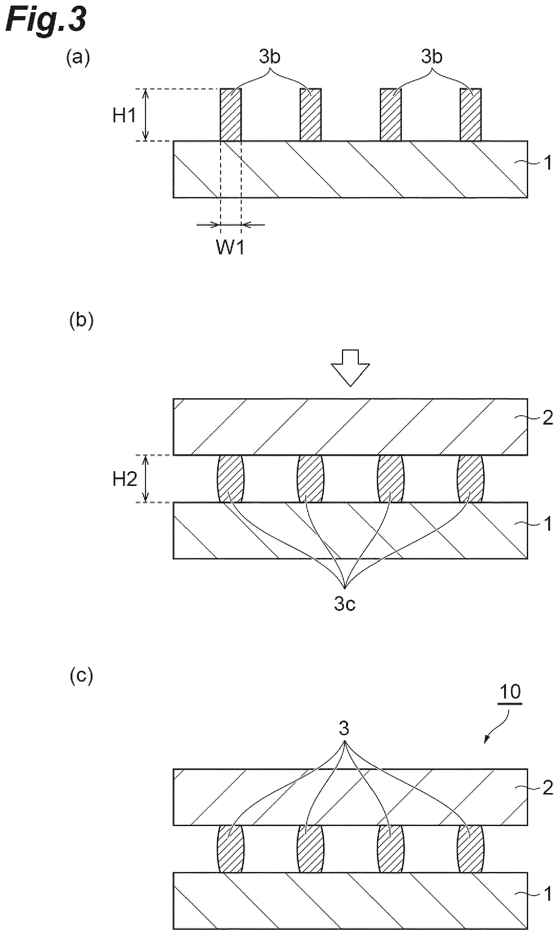

The method for manufacturing the bonded body 10 as described above includes a step of forming the copper paste in a pillar shape on the first member 1, and then mounting the second member 2 on the first member to provide pillar precursor between the first member 1 and the second member 2 (hereinafter, also referred to as "first step"), and a step of sintering the pillar precursor to form the sintered copper pillar 3 (hereinafter, also referred to as "second step"). Hereinafter, description will be made in detail with reference to FIG. 2 and FIG. 3.

(First Step)

In the first step, first, copper paste 3a is formed on the first member 1 in a pillar shape by printing or the like, for example, as illustrated in FIG. 2.

As a printing method of the copper paste, for example, screen printing, transfer printing, offset printing, a jet printing method, a dispenser, a jet dispenser, a needle dispenser, a comma coater, a slit coater, a die coater, a gravure coater, a slit coat, a letterpress printing, engraving printing, gravure printing, stencil printing, soft lithography, bar coating, an applicator, a particle deposition method, a spray coater, a spin coater, a dip coater, electrodeposition coating, and the like can be used.

In the first step, the copper paste is preferably formed in a pillar shape by the screen printing or the stencil printing from the viewpoint that a manufacturing process is simple, shape stability is likely to be maintained, and thick-film printing is easy. In the screen printing and the stencil printing, for example, first, a metal mask 4 is disposed on the first member 1 (FIG. 2(a)). Next, the copper paste 3a is disposed on the first member 1 and the metal mask 4 (FIG. 2(b)). Next, the copper paste 3a is extended by using a squeegee 5, and a hole portion of the metal mask 4 is filled with the copper paste 3a (FIG. 2(c)). In this manner, copper paste 3b formed in a pillar shape is formed on the first member 1 (FIG. 3(a)).

A via diameter of the metal mask used in the screen printing or the stencil printing may be 30 $\mu$m or more and 200 $\mu$m or less, or 50 $\mu$m or more and 100 $\mu$m or less. Arrangement of holes may be in a lattice shape. A pitch interval may be 1 $\mu$m or more and 500 $\mu$m or less. A squeegee angle may be 10° or more and 90° or less, or 45° or more to 70° or less.

A printing height H1 may be 5 $\mu$m or more and 500 $\mu$m or less, or 10 $\mu$m or more and 200 $\mu$m or less. In addition, wet spreading W1 at a pillar end after printing may be 100 $\mu$m or less or 50 $\mu$m or less.

Next, for example, as illustrated in FIG. 3, the second member 2 is mounted on the first member (on the copper paste 3b formed in a pillar shape), and a pillar precursor 3c is provided between the first member 1 and the second member 2. Specifically, for example, as illustrated in FIG. 3(b), the second member 2 is mounted on the first member 1 by pressing the second member 2 from above the copper paste 3b formed in a pillar shape. In this manner, the pillar precursor 3c is provided between the first member 1 and the second member 2.

A method for mounting the second member 2 is not particularly limited, but may be a method using, for example, a chip mounter, a flip-chip bonder, and a positioning jig formed from carbon or ceramics in a case where the first member 1 and the second member 2 are micro devices and substrates.

A pressing depth (H1-H2) when mounting the second member 2 may be 500 $\mu$m or less, 100 $\mu$m or less, or 50 $\mu$m or less from the uppermost portion of the copper paste formed in a pillar shape. H2 is set in consideration of the sintered copper pillar that is formed or the height of the pillar precursor.

(Second Step)

In the second step, the pillar precursor 3c disposed between the first member 1 and the second member 2 is sintered. According to this, the sintered copper pillar 3 is formed, and the first member 1 and the second member 2 are bonded by the sintered copper pillar 3, thereby obtaining the bonded body 10 illustrated in FIG. 3(c).

The pillar precursor 3c may be appropriately dried from the viewpoint of suppressing flowing during sintering and occurrence of voids. A gas atmosphere during drying may be the air, an oxygen-free atmosphere such as nitrogen and a rare gas, or a reducing gas atmosphere such as hydrogen and formic acid. A drying method may be drying by standing at room temperature, drying by heating, or drying under reduced pressure. In the drying by heating or the drying under reduced pressure, for example, a hot plate, a hot-air dryer, a hot-air heating furnace, a nitrogen dryer, an infrared dryer, an infrared heating furnace, a far-infrared heating furnace, a microwave heating device, a laser heating device, an electromagnetic heating device, a heater heating device, a steam heating furnace, a hot plate press device, and the like can be used. A drying temperature and drying time may be appropriately adjusted in conformity to the kind and the amount of the organic dispersion medium and the flexibility imparting component which are used. The drying temperature and the drying time may be set to, for example, 30 seconds or longer and 120 minutes or shorter at 50°C or more and 180°C or less.

Sintering of the pillar precursor 3c can be performed by a heating treatment. In the heating treatment, for example, a hot plate, a hot-air dryer, a hot-air heating furnace, a nitrogen dryer, an infrared dryer, an infrared heating furnace, a far-infrared heating furnace, a microwave heating device, a laser heating device, an electromagnetic heating device, a heater heating device, a steam heating furnace, and the like can be used. Sintering of the pillar precursor 3c may be performed without pressurization.

A gas atmosphere during sintering may be a reducing gas atmosphere from the viewpoint of removing copper particles included in the pillar precursor 3c or surface oxides of an adhesive surface. Examples of the reducing gas atmosphere include a pure hydrogen gas atmosphere, a mixed gas atmosphere of hydrogen and nitrogen which is represented by a forming gas, a nitrogen atmosphere containing a formic acid gas, a mixed gas atmosphere of hydrogen and a rare gas, and a rare gas atmosphere containing a formic acid gas.

In a case where a diameter of the pillar precursor 3c is small (particularly, 200 $\mu$m or less), since the formic acid enters the inside of the pillar precursor 3c, the copper particles are likely to be reduced, and the copper particles can be sufficiently sintered at the reducing gas atmosphere containing the formic acid gas. In this case, sintering can be performed by using a formic acid reflow furnace, and the degree of sintering can be efficiently improved.

The highest temperature reached during heating treatment may be 150°C or more and 300°C or less, 170°C or more and 250°C or less, or 200°C or more and 250°C or less from the viewpoint of causing sintering to progress sufficiently and the viewpoint of reducing thermal damage to members such as a micro device and a substrate and improving a yield ratio. When the highest temperature reached is 150°C or higher, even when the highest temperature reached holding time is 60 minutes or shorter, sintering tends to progress sufficiently. The highest temperature reached may be 180°C or more and 250°C or less, or 190°C or more and 225°C or less from the viewpoint of further reducing peeling at the interface of the sintered copper pillar and the bonding members while causing sintering to progress sufficiently in short time.

The highest temperature reached holding time may be 1 minute or longer and 60 minutes or shorter, 1 minute or longer and shorter than 40 minutes, or 1 minute or longer and shorter than 30 minutes from the viewpoint of sufficiently removing the organic dispersion medium and the flexibility imparting component, and the viewpoint that sintering progresses sufficiently or a yield ratio is improved. In a case where the highest temperature reached is set to 180°C or more and 250°C or less, or 190°C or more and 225°C or less, the highest temperature reached holding time is preferably set to 40 minutes or longer and 80 minutes or shorter, and more preferably 50 minutes or longer and 70 minutes or shorter from the viewpoint of causing sintering to progress sufficiently and further reducing peeling at the interface of the sintered copper pillar and the bonding members.

Temperature-rising time up to the highest temperature reached may be 10 minutes or shorter, 7 minutes or shorter, or 5 minutes or shorter from the viewpoint of suppressing a thermal stress caused by a thermal history of the bonding members and further reducing peeling at the interface of the sintered copper pillar and the bonding members. The temperature-rising time up to the highest temperature reached may be 1 minute or longer from the viewpoint of sufficiently removing the dispersion medium from the pillar.

Hereinbefore, a bonded body of an embodiment and a method for manufacturing the bonded body have been described, but the invention is not limited to the above-described embodiment.

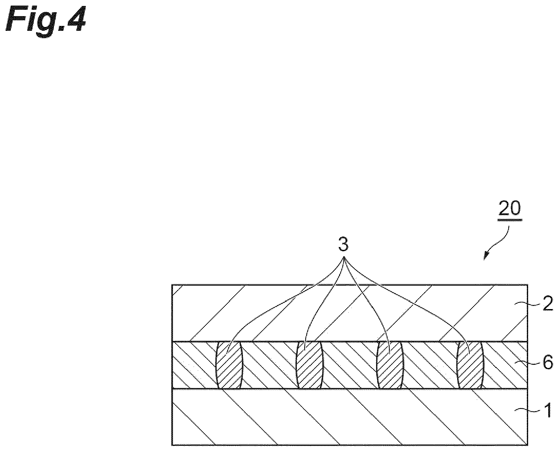

For example, the method for manufacturing the bonded body may further include a step of filling the vicinity of the sintered copper pillar with a resin. In this case, as illustrated in FIG. 4, a bonded body 20 in which a sealing material 6 is provided between the first member 1 and the second member 2 is obtained.

As the sealing material, a sealing material for compression molding, a liquid sealing material, a transfer molding sealing material, a sealing material for an underfill, and the like can be used from the viewpoint of protecting bonding portions from heat, humidity, and impact and further improving connection reliability.

## Examples

Hereinafter, the invention will be described in more detail with reference to Experimental Examples, but the invention is not limited to the following Experimental Examples.

<Preparation of Materials>

Materials used in Experimental Examples are described below.

[Copper Particles]

· CH-0200 (product name, manufactured by MITSUI MINING & SMELTING CO., LTD., shape: spherical shape, volume-average particle size ($D_{50}$ particle size): 0.26 $\mu$m, specific surface area: 4.1 m$^2$/g, aspect ratio: less than 2, surface treatment agent: dodecanoic acid)
· CT-500 (product name, manufactured by MITSUI MINING & SMELTING CO., LTD., shape: flake shape, volume-average particle size ($D_{50}$ particle size): 0.51 $\mu$m, specific surface area: 3.4 m$^2$/g, aspect ratio: 3 or more
· MAC-025KFD (product name, manufactured by FUKUDA METAL FOIL & POWDER CO., LTD., shape: flake shape, volume-average particle size ($D_{50}$ particle size): 5.90 $\mu$m, specific surface area: 0.73 m$^2$/g, aspect ratio: 3 or more)
· MAC-025K (product name, manufactured by FUKUDA METAL FOIL & POWDER CO., LTD., shape: spherical shape, volume-average particle size ($D_{50}$ particle size): 2.65 $\mu$m, specific surface area: 0.46 m$^2$/g, aspect ratio: less than 2)

[Organic Dispersion Medium]

· octyl octanoate (manufactured by SAFC)
· 2-ethylhexyl stearate (manufactured by Kao Corporation, product name: EH-S)

[Bonding Members]

· Cu plate (C1020, size: 19 mm $\times$ 25 mm, thickness: 3 mm)
· Si chip (bonding surface: Cu, size: 3 mm $\times$ 3 mm, thickness: 150 $\mu$m)

<Experimental Examples 1 to 7>

(Preparation of Copper Paste)

14.1 g of organic dispersion medium (octyl octanoate : 2-ethylhexyl stearate = 3 : 7) and 143 g of CH-0200 were put into a plastic container, and the mixture was stirred by using a rotation and revolution type stirrer (Planetary Vacuum Mixer ARV-310, manufactured by THINKY CORPORATION). Specifically, the mixture was stirred at 1000 rpm for 4 minutes under normal pressure, then stirred at 2000 rpm for 1 minute under reduced pressure five times, and further stirred at 1000 rpm for 1 minute under normal pressure. Next, the obtained mixture was treated at 12000 rpm by using a disk-type dispersing device (Disperizer CDMX-150TH, manufactured by SINTOKOGIO, LTD.) to prepare intermediate slurry.
Next, the intermediate slurry, copper particles other than CH-0200 as shown in Table 1, and organic dispersion medium (octyl octanoate : 2-ethylhexyl stearate = 3 : 7 (mass ratio)) were added to a mortar and were kneaded for 10 minutes. Then, the resultant mixture was stirred at 2000 rpm for 1 minute by using a rotation and revolution type stirrer under normal pressure to prepare copper paste (copper paste 1 to copper paste 7) of Experimental Examples 1 to 7. Note that, a blending amount of the copper particles was adjusted so that the content based on the total mass of copper particles in the copper paste becomes a value shown in Table 1. In addition, the blending amount of the organic dispersion medium was adjusted so that the total mass of the copper particles in the copper paste becomes 92% by mass.

[Table 1]

| Copper particles | Unit | Experimental Examples | | | | | | |
|---|---|---|---|---|---|---|---|---|
| | | 1 | 2 | 3 | 4 | 5 | 6 | 7 |
| CH-0200 | mass% | 80 | 70 | 50 | 40 | 50 | 60 | 50 |
| CT-500 | mass% | - | - | - | 30 | 20 | 10 | 20 |
| MA-CO25KFD | mass% | 20 | 30 | 50 | 30 | 30 | 30 | - |
| MA-CO25K | mass% | - | - | - | - | - | - | 30 |

[Manufacturing of Bonded Body]

Bonded bodies (bonded bodies 1 to 7) of Experimental Examples 1 to 7 were manufactured by using the copper paste (copper paste 1 to copper paste 7) in Experimental Examples 1 to 7. Specifically, first, a stainless steel metal mask (thickness: 70 μm) having a circular opening was mounted on the Cu plate. Next, the copper paste was applied onto the Cu plate by stencil printing using a metal squeegee. An opening diameter of the metal mask was 150 μm and a pitch of the opening was 500 μm. According to this, a pillar precursor (pillar-shaped copper paste) was formed on the Cu plate.

Next, an Si chip was mounted on the Cu plate (on the pillar precursor) by using a flip-chip bonder (T-3000-FC-3, manufactured by Dr. Tresky AG). Next, the pillar precursor was sintered by performing a heating treatment using a sintering and bonding furnace (manufactured by SHINKO SEIKI CO., LTD.) to form a sintered copper pillar, and the Cu plate and the Si chip were bonded through the sintered copper pillar. A gas atmosphere during sintering was set to a formic acid atmosphere. As sintering conditions, in Experimental Examples 1 to 3, the highest reached temperature was set to 225°C, holding time at the highest reached temperature was set to 1 hour, and temperature rising time up to the highest reached temperature was set to 20 minutes. In Experimental Examples 4 to 7, the highest reached temperature was set to 200°C, holding time at the highest reached temperature was set to 1 hour, and temperature rising time up to the highest reached temperature was set to 5 minutes.

[Evaluation of Bonded Body: Cross-sectional Morphology Observation]

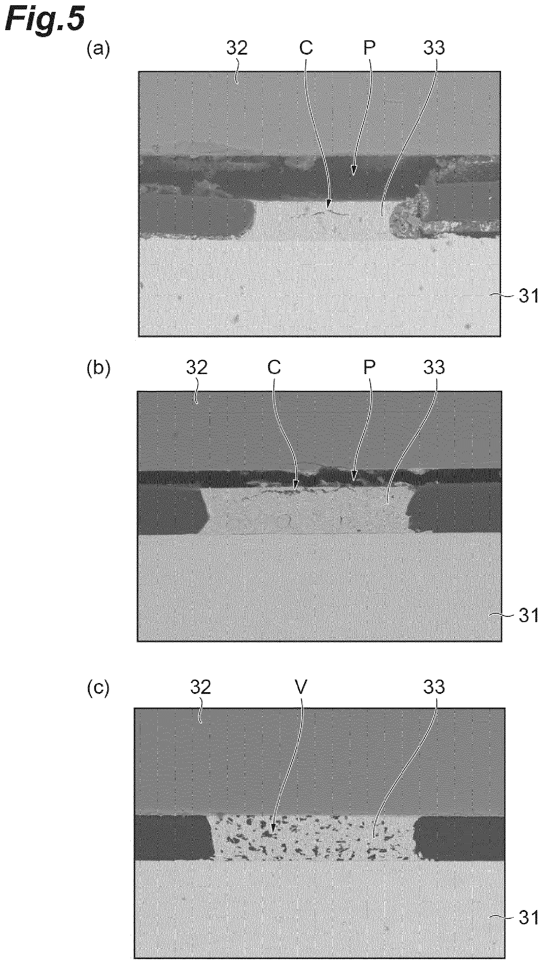

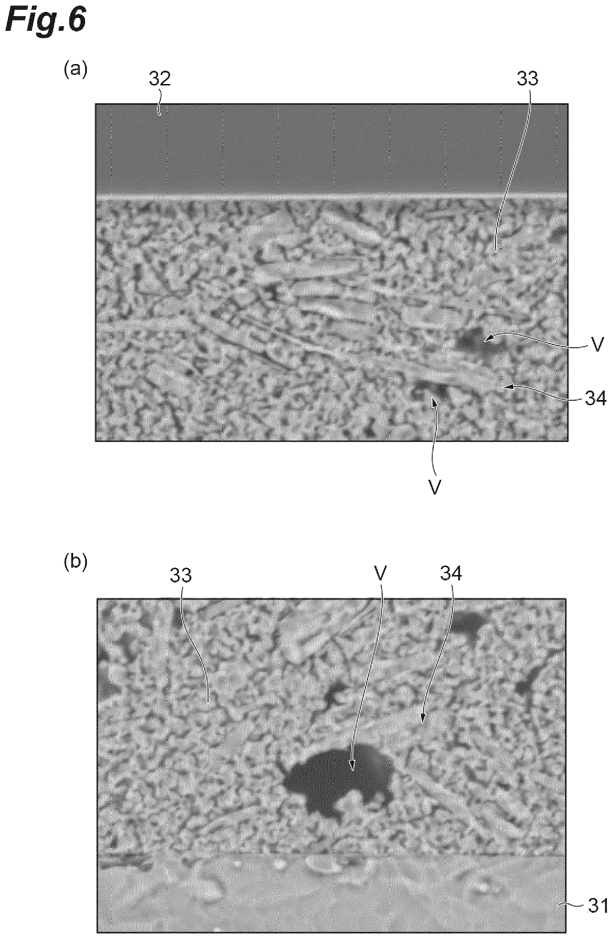

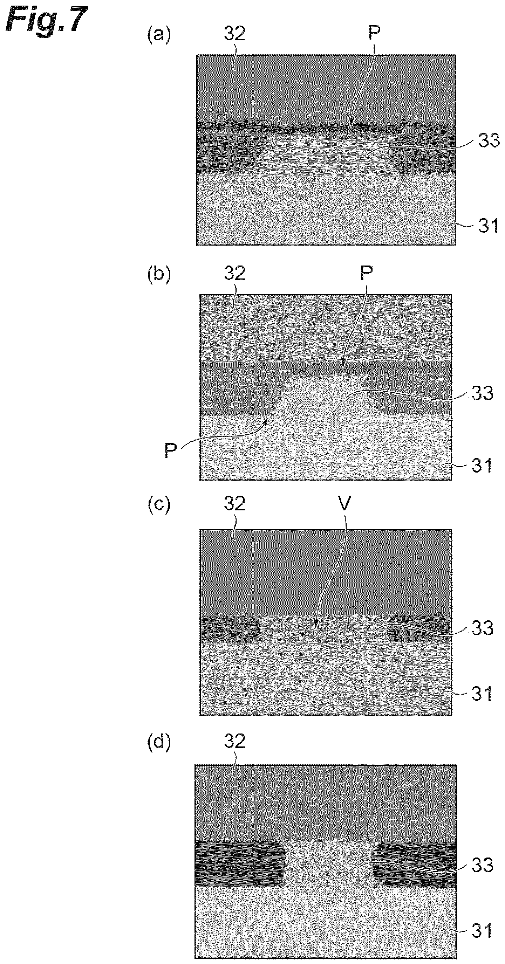

The bonded body was fixed in a cup with sample clip (Samplklip I, manufactured by Buehler), an epoxy casting resin (Epomount, manufactured by Refine Tec Ltd.) was poured to the periphery of the bonded body until the bonded body was embedded, the bonded body was stood still in a vacuum desiccator, and a pressure was reduced for 1 minute for degassing. Then, the bonded body was left as is at room temperature (25°C) for 10 hours to cure the epoxy casting resin. Next, the casted sample was cut out in the vicinity of a cross-section to be observed by using a refine saw excel (RCB-961, manufactured by Refine Tec Ltd.) equipped with a diamond cutting wheel (11-304, manufactured by Refine Tec Ltd.). Next, the cross-section was ground with a polishing device (Refine Polisher Hv, manufactured by Refine Tec Ltd.) equipped with water-resistant abrasive paper (Carbomac paper, manufactured by Refine Tec Ltd.) to obtain a crack-free cross-section in the Cu plate and the Si chip. Next, a surplus casting resin was ground and finished to a size that can be installed to a cross-section polisher (CP) processing device. Next, the sample cut by the method was subjected to flat milling by using CP processing device (IM4000, manufactured by Hitachi, Ltd.) under conditions of an acceleration voltage of 6 kV, an argon gas flow rate of 0.07 to 0.1 cm$^3$/minute, and processing time of 20 minutes. Next, platinum was sputtered to obtain a platinum film having a thickness of 10 nm by using a sputtering device (ION SPUTTER, manufactured by Hitachi High-Tech Co., Ltd.), thereby obtaining a sample for SEM observation. Next, a surface (cross-section of the bonded body) of the sample for SEM observation on which the platinum film is formed was observed at various magnifications with a SEM device (ESEM XL30, manufactured by Philips). At this time, an application voltage was set to 10 kV. Cross-sectional SEM images of the bonded bodies 1 to 7 are shown in FIG. 5 to FIG. 7. FIGS. 5(a), 5(b), and 5(c) are cross-sectional SEM images of the bonded bodies 1 to 3 (magnification: 500 times). FIGS. 6(a) and 6(b) are cross-sectional SEM images of the bonded body 3 (magnification: 10000 times). FIGS. 7(a) to 7(d) are cross-sectional SEM images of the bonded bodies 4 to 7 (magnification: 500 times). In FIG. 5 to FIG. 7, the Cu plate is indicated by a reference numeral 31, the Si chip is indicated by a reference numeral 32, the sintered copper pillar is indicated by a reference numeral 33, MA-025KFD (flake-shaped micro copper particles) are indicated by a reference numeral 34, a peeled portion is indicated by a letter P, a void portion is indicated by a letter V, and a cracked portion is indicated by a letter C.

As illustrated in FIG. 5, in the bonded bodies 1 and 2, peeling was observed at an interface of the Si chip and the sintered copper pillar, and cracks in a horizontal direction was observed in the sintered copper pillar. In contrast, in the bonded body 3, peeling was not observed at the interface of the Si chip and the sintered copper pillar. From this, it was confirmed that the copper paste 3 is more excellent in bonding properties in comparison to the copper paste 1 and the copper paste 2. However, in the bonded body 3, as illustrated in FIG. 5 and FIG. 6, voids with a size of 1 to 10 μm were observed in the vicinity of MA 025KFD in the sintered copper pillar. Occurrence of the voids is assumed because gaps between copper particles in the copper paste increase due to an increase in MA-025KFD, and copper particles burying the gaps are insufficient.

As illustrated in FIG. 7, in the bonded bodies 4 to 6, cracks were not observed in the sintered copper pillar. The reason for this is assumed because CT-500 as sub-micro copper particles having a size larger than a size of CH-0200 was used, and thus progress of excessive sintering is suppressed and volume shrinkage during sintering was suppressed. However, in the bonded bodies 4 and 5, peeling was observed at the interface of the Si chip and the copper pillar, and in the bonded body 6, voids were observed in the sintered copper pillar. On the other hand, in the bonded body 7, peeling was not observed at the interface of the Si chip and the sintered copper pillar, and voids and cracks were also not observed in the sintered copper pillar. The reason for this is assumed because MA-025K as spherical micro copper particles were used instead of MA-025FKD as flake-shaped micro copper particles, and thus a denser sintered copper pillar could be formed.

**Reference Signs List**

1: first member, 2: second member, 3, 33: sintered copper pillar, 3a: copper paste, 4: metal mask, 5: squeegee, 10, 20: bonded body, 31: Cu plate, 32: Si chip, P: peeling, V: void, C: crack.

**Claims**

1.  Copper paste for forming a sintered copper pillar, comprising copper particles and an organic dispersion medium,

    wherein the copper paste comprises first sub-micro copper particles having a volume-average particle size of 0.05 to 0.35 $\mu$m, second sub-micro copper particles having a volume-average particle size of 0.5 to 1.5 $\mu$m, and spherical micro copper particles having a volume-average particle size of 2 to 5 $\mu$m as the copper particles, a content of the first sub-micro copper particles is 40 to 70 % by mass on the basis of the total mass of the copper particles,
    a content of the second sub-micro copper particles is 10 to 40 % by mass on the basis of the total mass of the copper particles, and
    a content of the spherical micro copper particles is 15 to 45 % by mass on the basis of the total mass of the copper particles.

2.  The copper paste for forming a sintered copper pillar according to claim 1,
    wherein the first sub-micro copper particles have a spherical shape, and the second sub-micro copper particles have a flake shape.

3.  The copper paste for forming a sintered copper pillar according to claim 1 or 2,
    wherein a mass ratio of the content of the spherical micro copper particles to the total of the content of the first sub-micro copper particles and the content of the second sub-micro copper particles is 0.20 to 0.50.

4.  The copper paste for forming a sintered copper pillar according to any one of claims 1 to 3,
    wherein a mass ratio of the content of the second sub-micro copper particles to the content of the first sub-micro copper particles is 0.15 to 0.45.

5.  The copper paste for forming a sintered copper pillar according to any one of claims 1 to 4,
    wherein a content of the organic dispersion medium is 5 to 70 % by mass on the basis of the total mass of the copper paste.

6.  A method for manufacturing a bonded body comprising a first member, a second member, and a sintered copper pillar that bonds the first member and the second member to each other, the method comprising:

    a step of forming the copper paste according to any one of claims 1 to 5 in a pillar shape on the first member, and then mounting the second member on the first member to provide a pillar precursor between the first member and the second member; and
    a step of sintering the pillar precursor to form the sintered copper pillar.

# Fig.1

*Fig.2*

(a)

(b)

(c)

# *Fig.3*

(a)

(b)

(c)

# Fig.4

## Fig.5

(a)

(b)

(c)

## Fig.6

(a)

(b)

## Fig.7

(a)

(b)

(c)

(d)

## INTERNATIONAL SEARCH REPORT

| International application No. |
|---|
| **PCT/JP2022/011427** |

**A. CLASSIFICATION OF SUBJECT MATTER**

*B22F 7/08*(2006.01)i; *B22F 9/00*(2006.01)i; *H01B 1/00*(2006.01)i; *H01B 1/22*(2006.01)i; *H01L 21/60*(2006.01)i;
*H01R 11/01*(2006.01)i; *B22F 1/00*(2022.01)i; *B22F 1/052*(2022.01)i; *B22F 1/06*(2022.01)i

FI: B22F1/052; B22F1/00 L; B22F1/06; B22F7/08 C; B22F9/00 B; H01B1/00 H; H01B1/00 K; H01B1/22 A; H01L21/60 311Q; H01L21/92 603A; H01R11/01 501Z

According to International Patent Classification (IPC) or to both national classification and IPC

**B. FIELDS SEARCHED**

Minimum documentation searched (classification system followed by classification symbols)

B22F7/08; B22F9/00; H01B1/00; H01B1/22; H01L21/60; H01R11/01; B22F1/00; B22F1/052; B22F1/06

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 08-017241 A (MITSUBOSHI BELTING LTD.) 19 January 1996 (1996-01-19)<br>entire text | 1-6 |
| A | JP 2020-045514 A (HITACHI CHEMICAL CO., LTD.) 26 March 2020 (2020-03-26)<br>entire text | 1-6 |
| A | JP 2018-111856 A (HITACHI CHEMICAL CO., LTD.) 19 July 2018 (2018-07-19)<br>entire text | 1-6 |
| A | JP 2014-239040 A (HERAEUS PRECIOUS METALS NORTH AMERICA CONSHOHOCKEN LLC) 18 December 2014 (2014-12-18)<br>entire text | 1-6 |
| A | CN 111761049 A (GUANGZHOU NEOGENE THERMAL MANAGEMENT TECHNOLOGY CO., LTD.) 13 October 2020 (2020-10-13)<br>entire text | 1-6 |

☐ Further documents are listed in the continuation of Box C.　　☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **05 April 2022** | **19 April 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

| | International application No. |
|---|---|
| | **PCT/JP2022/011427** |

| Patent document cited in search report | | | Publication date (day/month/year) | Patent family member(s) | | | Publication date (day/month/year) |
|---|---|---|---|---|---|---|---|
| JP | 08-017241 | A | 19 January 1996 | US | 5807508 | A | |
| | | | | entire text | | | |
| | | | | EP | 0779773 | A1 | |
| JP | 2020-045514 | A | 26 March 2020 | (Family: none) | | | |
| JP | 2018-111856 | A | 19 July 2018 | (Family: none) | | | |
| JP | 2014-239040 | A | 18 December 2014 | US | 2014/0363681 | A1 | |
| | | | | entire text | | | |
| | | | | CN | 104240790 | A | |
| | | | | KR | 10-2014-0143714 | A | |
| CN | 111761049 | A | 13 October 2020 | TW | 202037682 | A | |

Form PCT/ISA/210 (patent family annex) (January 2015)

**EP 4 299 216 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160351529
- JP 2020045514 A